# EUROPÄISCHE PATENTSCHRIFT

(11) **EP 2 191 516 B1**
(45) Veröffentlichungstag und Bekanntmachung des Hinweises auf die Patenterteilung: **11.07.2012**
(21) Anmeldenummer: 08801311.5
(22) Anmeldetag: 09.09.2008
(51) Int. Cl.: H01L 31/055

(54) **PHOTOVOLTAISCHE ANORDNUNG MIT OPTISCH AKTIVER GLASKERAMIK**
PHOTOVOLTAIC ASSEMBLY COMPRISING AN OPTICALLY ACTIVE GLASS CERAMIC
DISPOSITIF PHOTOVOLTAÏQUE COMPORTANT UNE VITROCÉRAMIQUE OPTIQUEMENT ACTIVE

(30) Priorität: 11.09.2007 DE 102007043215
(43) Veröffentlichungstag der Anmeldung: 02.06.2010
(73) Patentinhaber: Fraunhofer-Gesellschaft zur Förderung der angewandten Forschung e.V., 80686 München (DE)
(72) Erfinder: WEHRSPOHN, Ralf, Boris, 06114 Halle (DE); SCHWEIZER, Stefan, 33098 Paderborn (DE)
(74) Vertreter: Rösler, Uwe
(86) Internationale Anmeldenummer: PCT/DE2008/001507
(87) Internationale Veröffentlichungsnummer: WO 2009/033466

(56) Entgegenhaltungen:
- EP-A- 1 130 657
- WO-A2-2007/133344
- DE-A1- 2 926 191
- JP-A- 2005 327 910
- US-A1- 2006 169 971
- US-A1- 2007 137 693
- QIU J ET AL: "Phenomenon and mechanism of long-lasting phosphorescence in Eu<2+>-doped aluminosilicate glasses" JOURNAL OF THE PHYSICS AND CHEMISTRY OF SOLIDS ELSEVIER UK, Bd. 59, Nr. 9, September 1998 (1998-09), Seiten 1521-1525, XP002514843 ISSN: 0022-3697
- PRIOLO FRANCESCO ET AL: "Role of the energy transfer in the optical properties of undoped and Er-doped interacting Si nanocrystals" JOURNAL OF APPLIED PHYSICS, AMERICAN INSTITUTE OF PHYSICS. NEW YORK, US, Bd. 89, Nr. 1, 1. Januar 2001 (2001-01-01), Seiten 264-272, XP012051961 ISSN: 0021-8979
- REISFELD R ET AL: "PHOTOSTABLE SOLAR CONCENTRATORS BASED ON FLUORESCENT GLASS FILMS" SOLAR ENERGY MATERIALS AND SOLAR CELLS, ELSEVIER SCIENCE PUBLISHERS, AMSTERDAM, NL, Bd. 33, Nr. 4, 1. August 1994 (1994-08-01), Seiten 417-427, XP000461957 ISSN: 0927-0248
- TRUPKE T ET AL: "Improving solar cell efficiencies by up-conversion of sub-band-gap light" JOURNAL OF APPLIED PHYSICS, AMERICAN INSTITUTE OF PHYSICS. NEW YORK, US, Bd. 92, Nr. 7, 1. Oktober 2002 (2002-10-01), Seiten 4117-4122, XP012057396 ISSN: 0021-8979
- DIAW D: "Effect of ion-implanted Eu<+3> on the conversion efficiency of amorphous silicon solar cell" SOLAR ENERGY MATERIALS AND SOLAR CELLS, ELSEVIER SCIENCE PUBLISHERS, AMSTERDAM, NL, Bd. 53, Nr. 3-4, 1. Juni 1998 (1998-06-01), Seiten 379-383, XP004148864 ISSN: 0927-0248
- SCHULER ET AL: "Quantum dot containing nanocomposite thin films for photoluminescent solar concentrators" SOLAR ENERGY, PERGAMON PRESS. OXFORD, GB, Bd. 81, Nr. 9, 30. August 2007 (2007-08-30), Seiten 1159-1165, XP022223528 ISSN: 0038-092X
- LI H ET AL: "PREPARATION OF TRANSPARENT INORGANIC-ORGANIC COMPOSITE PHOSPHORS INCORPORATED WITH EUROPIU (III) COMPLEXES" ELECTROCHEMICAL AND SOLID-STATE LETTERS, IEEE SERVICE CENTER, PISCATAWAY, NJ, US, Bd. 2, Nr. 7, 1. Januar 1999 (1999-01-01), Seiten 354-356, XP000826376 ISSN: 1099-0062
- BAKUEVA L ET AL: "Size-tunable infrared (1000-1600 nm) electroluminescence from PbS quantum-dot nanocrystals in a semiconducting polymer" APPLIED PHYSICS LETTERS, AIP, AMERICAN INSTITUTE OF PHYSICS, MELVILLE, NY, Bd. 82, Nr. 17, 28. April 2003 (2003-04-28), Seiten 2895-2897, XP012033900 ISSN: 0003-6951

## Beschreibung

### Technisches Gebiet

Die Erfindung betrifft eine Solarzelle sowie ein Verfahren zur Herstellung einer Solarzelle, die wenigstens einen photovoltaischen Schichtbereich und wenigstens eine Wechselwirkungsschicht aufweist, in der eine Up- oder eine Down-Konversion von Photonen derart erfolgt, dass ein breiterer Anteil des Sonnenspektrums in der Solarzelle in elektrische Energie umgewandelt werden kann.

### Stand der Technik

Solarzellen wandeln die Energie des Sonnenlichts direkt in elektrische Energie um. Am weitesten verbreitet sind bisher Solarzellen auf Halbeiterbasis, die je nach Halbleitermaterial vor allem das Sonnenspektrum im Bereich des sichtbaren und des nahen Infrarotbereiches ausnützen. Die Solarzellen auf Halbleiterbasis bestehen im Wesentlichen aus einer p- und einer n-dotierten Halbleiterschicht, die zwischen zwei Elektroden angeordnet sind. An der Grenzfläche zwischen p- und n-Schicht, dem pn-Übergang, bildet sich durch Diffusion von Ladungsträgern eine Raumladungszone aus, die zu einer an den Elektroden abgreifbaren elektrischen Spannung führt.

Gelangt ein Photon ausreichender Energie, d. h. mit einer Energie größer als die Bandlückenenergie E_{g} des Halbleitermaterials, in diese Raumladungszone, wird es mit einer gewissen Absorptionswahrscheinlichkeit absorbiert und regt ein Elektron aus dem Valenzband des Halbleitermaterials in das Leitungsband des Halbleitermaterials an. Dabei entsteht im Valenzband ein Loch. Das in das Leitungsband angeregte Elektron und das Loch bilden ein so genanntes Elektron-Loch-Paar. Durch die über der Raumladungszone anliegende Potentialdifferenz wird das Elektron-Loch-Paar räumlich getrennt. Elektron und Loch wandern in entgegen gesetzter Richtung zu den Elektroden, wodurch letztlich ein elektrischer Stromfluss generiert wird.

Wie die vorstehenden Zusammenhänge zeigen, können lediglich Photonen mit einer Mindestenergie, die zumindest der Bandlückenenergie des Halbleiters entspricht, in elektrische Energie umgewandelt werden, so dass der theoretisch erreichbare Wirkungsgrad zur Wandlung von Photonenenergie in elektrische Energie aus Sonnenlicht mit Hilfe herkömmlicher Solarzellen begrenzt ist. Darüber hinaus geht beispielsweise bei der Erzeugung eines Elektron-Lochpaares in einer Halbleiter-Solarzelle mit einem hochenergetischen Photon, d. h. einem Photon, dessen Energie deutlich größer als die Bandlücke ist, z. B. größer 2-mal E_{g}, ein großer Teil der Photonenenergie durch Thermalisierung, d. h. durch nicht-strahlende Energieabgabe der erzeugten Ladungsträger verloren. Aus diesen Gründen liegt der theoretisch erreichbare Wirkungsgrad beispielsweise von Silizium-Solarzellen bei max. 30%. Der praktisch erreichbare Wirkungsgrad, in den darüber hinaus noch die Absorptionswahrscheinlichkeit eingeht, liegt weit darunter.

Neben Solarzellen auf Halbleiterbasis sind auch Ansätze bekannt, Solarzellen aus anderen Materialien herzustellen. Als Beispiele seien organische Solarzellen oder Farbstoffsolarzellen genannt. Allerdings sind bisher auch hier nur geringe Wirkungsgrade erzielt worden.

Es werden daher verschiedene Anstrengungen unternommen, den Wirkungsgrad von Solarzellen zu verbessern. Eine Möglichkeit zur Verbesserung des Wirkungsgrades besteht in der gezielten Nutzung eines breiteren spektralen Anteils des Sonnenlichts.

Bekannt sind so genannte Tandemzellen, die wenigstens zwei unterschiedliche, übereinander angeordnete Halberleiterschichtbereiche aufweisen, die jeweils zwei photovoltaische Schichten, d. h. Solarzellenbereiche mit unterschiedlichen energetischen Bandlücke bilden. Photonen, deren Energie kleiner ist als die Bandlücke des ersten Halbleitermaterials und die daher dieses erste Halbleitermaterial nahezu verlustfrei durchdringen, können in der zweiten, angrenzenden Solarzelle mit kleinerer Bandlücke absorbiert werden, sofern ihre Energie größer ist als die Bandlücke des zweiten Halbleitermaterials.

Weiterhin ist es bekannt, durch gezieltes Einbringen von Störstellen im Halbleitermaterial energetische Zwischenniveaus in der Bandlücke zu schaffen, wodurch auch Photonen mit einer geringeren Energie als die Bandlücke Elektronen über die Zwischenniveaus in das Leitungsband anregen können. Der Nachteil hierbei ist jedoch, dass durch die Zwischenniveaus auch zusätzliche nicht-strahlende Rekombinationskanäle für Elektron-Loch-Paare geschaffen werden, durch die erwünschte Verbesserung der Wirkungsgraderhöhung nur begrenzt möglich ist.

Eine weitere Möglichkeit zur Wirkungsgradsteigerung von Solarzellen besteht darin, außerhalb der eigentlichen Solarzelle, d. h. dem photovoltaischen Schichtbereich, in dem die Absorption und Ladungstrennung geschieht, Schichten anzuordnen, in denen eine Up-Konversion bzw. eine Down-Konversion der Photonenenergie im Wege von Zwei- oder Mehrphotonenprozessen stattfindet. Dabei werden bei der Up-Konversion aus niederenergetischen Photonen höher energetische und bei der Down-Konversion aus höherenergetischen Photonen mindestens ein niederenergetisches Photon erzeugt, wobei die erzeugten Photonen jeweils eine ausreichende Energie aufweisen, so dass sie in der photovoltaischen Schicht Ladungsträger erzeugen können.

Hierzu gehen aus der WO 03/079457 A1 Anordnungen hervor, in denen die eigentliche Solarzelle optisch mit einer einkristallinen Up-Konversion-Schicht samt Reflektorschicht und/oder einer einkristallinen Down-Konversion-Schicht gekoppelt ist, wodurch Steigerungen des theoretisch erreichbaren Wirkungsgrades bis über 60% erreichbar sind. Der Nachteil hierbei ist jedoch, dass eine Herstellung solcher einkristallinen Konversionsschichten teuer und daher für die großtechnische Fertigung von Solarmodulen wirtschaftlich als nicht realisierbar erscheint.

Weiter bekannt sind auch Arbeiten von Gibart et al., veröffentlicht in Jap. J. Appl. Phys; 35; 1996; 4401, bei denen eine mit Seltenen Erden-Elementen dotierte Keramik in Durchstrahlungsrichtung hinter einer GaAs-Solarzelle angeordnet wurde, mit dem Zweck eine Erhöhung des Wirkungsgrades bzw. der Quantenausbeute durch eine Up-Konversion von niederenergetischen Photonen (E<E_{g}) zu bewirken. Allerdings kommen Gibart et al. zu dem Schluss, dass eine praktische Anwendung der Up-Konversion nicht effektiv erscheint, da mit diesen Maßnahmen unter Anregung im infraroten Spektralbereich (1 Watt Leistung) lediglich Wirkungsgrade von 2,5% erreichbar waren.

Aus der US 2006/169971 A1 ist eine Solarzelle mir einer Wechselwirkungsschicht beschrieben, die eine Matrix aus anorganischem Material oder aus einem Polymerharz aufweist, in der Quanten-Dots mit einer Größenordnung zwischen 1 bis 10 Nanometern enthalten sind und die in der Lage sind, Photonen höherer Energie in Photonen niedrigerer Energie umzuwandeln, die letztlich von der photoaktiven Schicht der Solarzelle absorbiert werden.

Der Druckschrift
QIU J ET AL: "Phenomenon and mechanism of long-lasting phosphorescence in Eu<2+>-doped aluminosilicate glasses" JOURNAL OF THE PHYSICS AND CHEMISTRY OF SOLIDS ELSEVIER UK, Bd. 59, Nr. 9, September 1998 (1998-09), Seiten 1521-1525, XP002514843 ISSN: 0022-3697
sind Untersuchungen an lang andauernden phosphoreszierenden Erscheinungen von mit Europium dotierten Silikatgläsern zu entnehmen. Insbesondere beziehen sich die Untersuchungen auf mit Europium-Ionen dotierten Alumosilikat-Gläsern.

Ferner geht aus der nachveröffentlichten WO 2007/133344 A2 ein photovoltaisches Bauelement hervor, das über eine transparente Polymermatrix verfügt, in der zur Wellenlängenkonversion Phosphore enthalten sind, die mit seltenen Erden dotiert sind.

Der Druckschrift STRÜMPEL C ET AL: "modifying the solar spectrum to enhance silicon solar cell efficiency - An overviews of available materials" SOLAR ENRGY MATERIALS & SOLAR CELLS91 238- 249 30, october 2006 offenbart die Verwendung der Seltenen Erden bei Nanopartikeln ober nicht in einer glasmatrix.

### Darstellung der Erfindung

Es besteht die Aufgabe eine Solarzelle mit wenigstens einem photovoltaischen Schichtbereich, der in diesen einfallende Photonen, deren Photonenenergie über eine Mindestphotonenenergie Eₘᵢₙ liegt, zumindest teilweise absorbiert und elektrische Ladungsträger in Form von Elektron-Loch-Paaren freisetzt, die innerhalb des photovoltaischen Schichtbereiches räumlich trennbar und über wenigstens zwei mit dem photovoltaischen Schichtbereich elektrisch verbundene Elektroden unter Ausbildung einer elektrischen Spannung abgreifbar sind, sowie mit wenigstens einer den photovoltaischen Schichtbereich zumindest teilweise überdeckenden Wechselwirkungsschicht, in der zumindest ein Teil der einfallenden Photonen einer Wechselwirkung unter Emission von Photonen höherer oder niedrigerer Photonenenergie als jener der einfallenden Photonen unterliegt, sowie ein Verfahren zur Herstellung einer solchen Solarzelle derart weiterzubilden, dass sie einen verbesserten Wirkungsgrad aufweist, dass sie kostengünstig im industriellen Maßstab herstellbar ist und dass eine Verbesserung und Verbreiterung ihrer technischen Einsatzmöglichkeiten ermöglicht wird.

Gelöst wird die Aufgabe durch eine Solarzelle gemäß Patentanspruch 1. Die auf das Verfahren bezogene Aufgabe wird durch ein Verfahren gemäß dem Patentanspruch 6 gelöst. Den Erfindungsgedanken vorteilhaft weiterbildende Merkmale sind den jeweiligen Unteransprüchen sowie der weiteren Beschreibung, insbesondere unter Bezugnahme auf die Ausführungsbeispiele zu entnehmen.

Lösungsgemäß wird vorgeschlagen, eine gattungsgemäße Solarzelle mit den Merkmalen des Oberbegriffes des Anspruches 1 derart weiterzubilden, dass die Wechselwirkungsschicht in Form einer Glaskeramik ausgebildet ist, wobei die Glaskeramik eine Glasmatrix aufweist, in der lokal begrenzte Bereiche mit optisch aktivem Material, das die Struktur und Größe kristalliner Nanopartikel besitzt, vorgesehen sind, mit denen die einfallenden Photonen in Wechselwirkung treten, und dass das optisch aktive Material Elemente der Seltenen Erden aufweist.

So ist lösungsgemäß erkannt worden, dass nicht nur in einkristallinen Schichten hohe Quantenausbeuten für die Prozesse Up- bzw. Down-Konversion erreichbar sind, sondern dass bereits kristalline Nanopartikel eine hohe Quantenausbeute zeigen. Durch das Einbetten der Nanopartikel in eine Matrixstruktur können Wechselwirkungsschichten hergestellt werden, die den verschiedensten Anforderungen angepasst werden können, die beispielsweise ein Einkristall eines entsprechenden optischen Materials nicht erfüllen kann. Insbesondere sind viele Leuchtstoffe mechanisch spröde und teilweise sogar wasserlöslich oder wasseranziehend (hygroskopisch). Durch die Einbettung derartiger Systeme in eine Glasmatrix kann eine verbesserte mechanische und chemische Stabilität erhalten werden. Darüber hinaus kann die aufwändige und teure Herstellung von großen einkristallinen Schichten umgangen werden. Aus dem erfinderischen Gedanken heraus, optisch aktive Nanokristalle in eine Glasmatrix einzubetten, lassen sich viele neue Realisierungsmöglichkeiten ableiten, die nach dem Stand der Technik nicht möglich sind.

Die Matrixstruktur der Glasmatrix ist amorph. So wird die Wechselwirkungsschicht in Form einer Glaskeramik ausgebildet. Die Glaskeramik besteht aus einer Glasmatrix, in der optisch aktive Nanopartikel eingebettet sind. Glaskeramiken weisen besonders günstige thermomechanische Eigenschaften auf. Insbesondere ist der thermische Ausdehnungskoeffizient weitgehend variabel einstellbar; er kann sogar negativ oder Null sein. Ein weiterer Vorteil ist die mechanische Festigkeit und die kostengünstige Herstellung.

Das optisch aktive Material enthält Elemente der Seltenen Erden. Solches material enthält Nanophosphore wie bspw. mit Seltenen Erden dotierte Alkali-/Erdalkalihalogenid-Verbindungen sowie Aluminate und Borate, aber auch Silikate, Oxide, Sulfate, oder Phosphate.

Durch das Einbringen von Elementen der Seltenen Erden in die Nanokristalle können im Nanokristall energetische Zwischenniveaus erzeugt werden, die zur Konversion der Photonenenergie einfallender Photonen nutzbar sind. Die Quantenausbeute für die Konversion ist bei den lösungsgemäß vorgeschlagenen Nanopartikeln besonders hoch, da die Elemente der Seltenen Erden eine kristalline Umgebung erhalten, und so Rekombinationen von Photonen über nichtstrahlende Prozesse deutlich reduziert werden. Durch die Wahl eines entsprechenden Elementes der Seltenen Erden erfolgt in dem optisch aktiven Material eine Up- oder eine Down-Konversion, d. h. es werden aus zwei niederenergetischen Photonen ein höherenergetisches Photon bzw. aus einem höherenergetischen mindestens ein niederenergetisches Photon erzeugt.

In einer weiteren bevorzugten Ausführungsform weist das optisch aktive Material einen organischen Farbstoff auf. Diese organischen Farbstoffe sind meist aus mehreren aromatischen Ringen aufgebaut, wie etwa Fluorescein oder Rhodamin.

Das optisch aktive Material ist vorzugsweise derart gewählt, dass die im Rahmen der Wechselwirkung emittierten Photonen Photonenenergien aufweisen, die in den Absorptionsbereich des photovoltaischen Schichtbereichs der Solarzelle fallen. Durch geeignete Wahl des optisch aktiven Materials kann die Quantenausbeute für die Erzeugung von Elektron-Loch-Paaren und damit der Wirkungsgrad der gesamten Solarzellenanordnung merklich gesteigert werden.

Typischerweise sind Solarzellen nicht zuletzt aus Gründen des Schutzes vor äußeren Einflüssen mit einem Deckglas bzw. einer für das Sonnenlicht transparenten Deckschicht versehen. Infolgedessen bietet es sich an, die Wechselwirkungsschicht in Art dieser Deckschicht auszubilden, durch die der photovoltaischen Schichtbereich gegenüber äußeren Einflüssen geschützt gelagert ist. Erst die lösungsgemäße Anordnung der Wechselwirkungsschicht in Form einer Glaskeramik, die eine Glasmatrix mit eingebetteten Nanopartikeln aufweist, ermöglicht es, die Wechselwirkungsschicht beispielsweise resistent gegen Umwelteinflüsse, wie z. B. Feuchtigkeit oder Chemikalien, oder auch mechanisch stabil genug in Bezug auf mechanische Belastungen, wie z. B. Windlast oder Schneedruck, auszubilden.

Ferner ist es von Vorteil, den photovoltaischen Schichtbereich, der zusammen mit den Elektroden die eigentliche Solarzelle bildet, an gegenüberliegenden Seitenflächen mit je einer lösungsgemäß ausgebildeten Wechselwirkungsschicht zumindest teilweise zu bedecken. Eine der beiden Wechselwirkungsschichten enthält dabei optisch aktives Material, in dem eine Down-Konversion erfolgt. Die andere der wenigstens zwei Wechselwirkungsschichten enthält optisch aktives Material, in dem eine Up-Konversion erfolgt. Die Wechselwirkungsschichten können jeweils mittelbar oder unmittelbar an die jeweiligen Seitenflächen des photovoltaischen Schichtbereichs vorgesehen sein. In vorteilhafter Weise bietet es sich an, jeweils zwischen den Wechselwirkungsschichten und dem photovoltaischen Schichtbereich eine Art Kontaktschicht einzubringen, die gewährleistet, dass die Photonen, die in der Wechselwirkungsschicht erzeugt werden, möglichst verlustfrei in den photovoltaischen Schichtbereich einkoppeln, und nicht, z. B. aufgrund ungünstiger Brechungsindexverhältnisse, an den entsprechenden Grenzflächen reflektiert werden.

So sei angenommen, dass jene Wechselwirkungsschicht, in der die Down-Konversion erfolgt, als Lichteintrittsschicht dient und somit dem Lichteinfall zugewandt angeordnet ist. Zudem ist es günstig die andere Wechselwirkungsschicht, in der die Up-Konversion stattfindet, rückseitig, d. h. dem photovoltaischen Schichtbereich abgewandt, mit einer Reflektorschicht zu versehen, an der die Photonen, die beispielsweise in der Up-Konversionsschicht erzeugt werden und in einen von der eigentlichen abgewandten Raumwinkelbereich emittiert werden, und/oder die einfallenden Photonen, die ohne Wechselwirkung alle Schichten durchlaufen, zumindest teilweise reflektiert werden, so dass diese Photonen den photovoltaischen Schichtbereich passieren bzw. erneut passieren können. Hierdurch lässt sich die Absorptionsrate und damit verbunden der Wirkungsgrad bei der Erzeugung von Elektron-Loch-Paaren merklich erhöhen. Diese Reflektorschicht kann entweder direkt auf der Wechselwirkungsschicht aufgebracht sein oder aber auch anderweitig bspw. nicht galvanisch.

Wie bereits erwähnt basiert die Wechselwirkung zwischen den einfallenden Photonen und dem optisch aktiven Material auf Ein- oder Mehrphotonenprozessen. So ist es besonders vorteilhaft, wenn die Down-Konversionsschicht derart ausgebildet ist, dass im Rahmen der Down-Konversion eines hochenergetischen Photons mehr als ein Photon mit einer passenden Energie für den photovoltaischen Schichtbereich erzeugt wird. Dies führt zu einer weiteren Erhöhung der Quantenausbeute und damit des Wirkungsgrades.

In einer weiteren bevorzugten Ausführungsform ist die Wechselwirkungsschicht in einem Spektralbereich von 350 nm bis 1100 nm optisch transparent. Insbesondere kann durch die Wahl der Konzentration der Nanopartikel in der Glasmatrix erreicht werden, dass die Wechselwirkungsschicht genügend transparent ist und dass trotzdem hohe Quantenausbeuten realisiert werden können.

Die lösungsgemäße Solarzelle lässt sich in besonders vorteilhafter Weise mit einem Verfahren herstellen, das sich durch die folgenden Verfahrensschritte auszeichnet: In einem ersten Schritt wird die mindestens eine Wechselwirkungsschicht, in Form einer, eine Glasmatrix aufweisenden glaskeramiscken Schicht bereitgestellt, in deren Glasmatrix optisch aktive kristalline Nanopartikel enthalten sind, in die Elemente der Seltenen Erden eingebracht sind. In einem zweiten Schritt wird diese mindestens eine Wechselwirkungsschicht zumindest teilweise mittelbar oder unmittelbar auf einer technischen Oberfläche des photovoltaischen Schichtbereichs aufgebracht. Alternativ dazu besteht auch die Möglichkeit, die mindestens eine Wechselwirkungsschicht als Substrat zur Aufbringung des photovoltaischen Schichtbereichs zu verwenden.

Durch die lösungsgemäße Anordnung kristalliner, optisch aktiver Nanopartikel in einer Matrixstruktur können sowohl die optischen als auch mechanischen Eigenschaften der Wechselwirkungsschicht weitgehend unabhängig voneinander eingestellt werden. Dementsprechend gibt es eine Vielzahl von Verfahrensvarianten, die in den unterschiedlichsten Kombinationen von Matrixstruktur und Nanokristallen begründet sind.

In einer bevorzugten Verfahrenvariante wird eine erste Wechselwirkungsschicht zumindest teilweise überdeckend mittelbar oder unmittelbar auf einer ersten technischen Oberfläche des photovoltaischen Schichtbereichs aufgebracht. Je nachdem, ob der photovoltaische Schichtbereich nebst Elektrodenanordnung, sprich die Solarzelle, bereits als eine Art Halbfertigprodukt vorliegt, kann eine derartige Kombination mit der Wechselwirkungsschicht vorgenommen werden. Andernfalls lässt sich die Wechselwirkungsschicht als Substrat verwenden, auf dem die Herstellung der Solarzelle als solche möglich ist.

Anschließend wird eine zweite Wechselwirkungsschicht zumindest teilweise mittelbar oder unmittelbar auf einer zweiten technischen Oberfläche des photovoltaischen Schichtbereichs, die der ersten technischen Oberfläche gegenüber liegt, aufgebracht. Die Wechselwirkungsschichten bewirken jeweils eine Up-Konversion bzw. eine Down-Konversion von einfallenden Photonen derart, dass die emittierten Photonen ein für den photovoltaischen Schichtbereich optimalen Energiegehalt aufweisen. Besonders bevorzugt ist in Einfallsrichtung der Photonen eine Schichtabfolge der folgenden Art: Als erstes die Down-Konversionsschicht, dann der photovoltaische Schichtbereich und anschließend der Up-Konversionsschichtbereich.

In einem weiteren bevorzugten Verfahren wird eine technische Oberfläche der ersten oder der zweiten Wechselwirkungsschicht zumindest teilweise mittelbar oder unmittelbar mit einer Reflektorschicht versehen. Insbesondere handelt es sich hierbei um eine technische Oberfläche einer Up-Konversionsschicht, die dem photovoltaischen Schichtbereich abgewandt ist. Dadurch kann erreicht werden, dass Photonen, die den photovoltaischen Schichtbereich ohne Wechselwirkung durchlaufen haben, wieder in diesen zurückreflektiert werden. Dies führt wiederum zu einer Erhöhung der Quantenausbeute und damit des Wirkungsgrades der gesamten Solarzellenanordnung.

In einem weiteren bevorzugten Verfahren wird die mindestens eine Wechselwirkungsschicht in Form einer glaskeramischen Schicht bereitgestellt, in deren Glasmatrix optisch aktives Material in Form kristalliner Nanopartikel enthalten ist. Glaskeramiken weisen hervorragende mechanische, insbesondere thermomechanische, Eigenschaften auf. Zu nennen ist insbesondere der thermische Ausdehnungskoeffizient der glaskeramischen Schicht, der durch geeignete Dimensionierung in weiten Bereichen, sogar auf negative Werte eingestellt werden kann. Dies bietet besondere Vorteile, da der Ausdehnungskoeffizient der Glaskeramik an den anderer Materialien, mit denen die Glaskeramik verbunden werden soll, angepasst werden kann. Auf diese Weise können Spannungen aufgrund von Temperatur im Materialverbund vermieden werden, was zu einer Reduzierung der Schadensanfälligkeit führt.

Darüber hinaus können Glaskeramiken kostengünstig und in großen Dimensionen hergestellt werden, so dass beispielsweise Glaskeramiken, in denen Down-Konversion stattfindet, als Deckgläser für bereits bestehende Solarzellen/Solarmodule als Ersatz der bisher verwendeten Deckgläser eingesetzt werden können.

Besonders vorteilhaft ist es, die mindestens eine Wechselwirkungsschicht in Form einer Hochtemperaturglaskeramik bereitzustellen, so dass die Wechselwirkungsschicht als Substratmaterial eingesetzt werden kann, auf dem Halbleiterschichten, die den photovoltaischen Schichtbereich bilden, unmittelbar im Rahmen eines Herstellungsprozesses des photovoltaischen Schichtbereichs aufgebracht oder abgeschieden werden können. Der besondere Vorteil liegt hierbei in der hohen erzielbaren Quantenausbeute, da der Wechselwirkungsschichtbereich und der photovoltaischen Schichtbereich optimal optisch gekoppelt sind, d. h. insbesondere ohne Luftspalte, an denen Photonen aus dem Wechselwirkungsschichtbereich reflektiert werden.

Des Weiteren ist es von Vorteil, zwischen mindestens einer Wechselwirkungsschicht und der technischen Oberfläche des photovoltaischen Schichtbereichs eine Zwischenschicht zur besseren optischen Ankopplung einzubringen, d. h. eine Anpassung der Brechungsindizes von Wechselwirkungsschicht und Solarzelle. Zwischenschichten, die einen derart ausgewählten Brechungsindex aufweisen, dass Photonen besser von der Wechselwirkungsschicht in den photovoltaischen Schichtbereich einkoppeln, erhöhen direkt die Quantenausbeute und damit wiederum den Wirkungsgrad der Solarzellenanordnung.

In einem besonders bevorzugten Verfahren wird die mindestens eine Wechselwirkungsschicht durch Herstellen einer Glasschmelze gewonnen, in die das optisch aktive Material in Form kristalliner Nanopartikel beigemischt wird. Beispielsweise eignet sich als Glasschmelze eine Schmelze aus Fluorid-Glas, der Barium- und Chlor-Ionen sowie Ionen aus der Gruppe der Seltenen Erden zugesetzt werden. Durch Temperaturbehandlung bilden sich in der Glasschmelze kristalline Nanopartikel aus, an denen zumindest ein Teil der Ionen aus der Gruppe der Seltenen Erden anhaftet bzw. in denen zumindest ein Teil der Ionen aus der Gruppe der Seltenen Erden eingebaut ist. Die Temperaturbehandlung wird in Nähe der Glasübergangstemperatur nicht notwendiger in einer Schutzgasatmosphäre durchgeführt.

Als Nanopartikel eignen sich beispielsweise mit Erbium-Ionen dotierte Nanokristalle, die im Rahmen einer Up-Konversionsschicht Photonen niedrigerer Energie in Photonen höherer Energie umwandeln. Zu Zwecken der Down-Konversion eignen sich bspw. Europium-Ionen, die Photonen höherer Energie im Rahmen von Einphotonenprozessen in niederenergetischere Photonen umwandeln. Fügt man der Glasschmelze ein Gemisch aus Europium- und Gadolinium-Ionen bei, so können Photonen höhere Energie in Photonen niedrigere Energie im Rahmen so genannter Zweiphotonenprozesse umgewandelt werden.

### Kurze Beschreibung der Erfindung

Die Erfindung wird nachstehend ohne Beschränkung des allgemeinen Erfindungsgedankens anhand von Ausführungsbeispielen unter Bezugnahme auf die Zeichnungen exemplarisch beschrieben. Es zeigen:
Fig. 1 Stark schematisierte Anordnung einer erfindungsgemäßen Solarzelle gemäß dem ersten Ausführungsbeispiel mit einem photovoltaischen Schichtbereich, der aus parallel zum Deckglas angeordneten Schichten besteht.
Fig. 2 Stark schematisierte Anordnung einer erfindungsgemäßen Solarzelle gemäß dem zweiten Ausführungsbeispiel mit einem photovoltaischen Schichtbereich, der aus zur einfallenden Strahlung parallel angeordneten Schichten besteht.

### Wege zur Ausführung der Erfindung, gewerbliche Verwendbarkeit

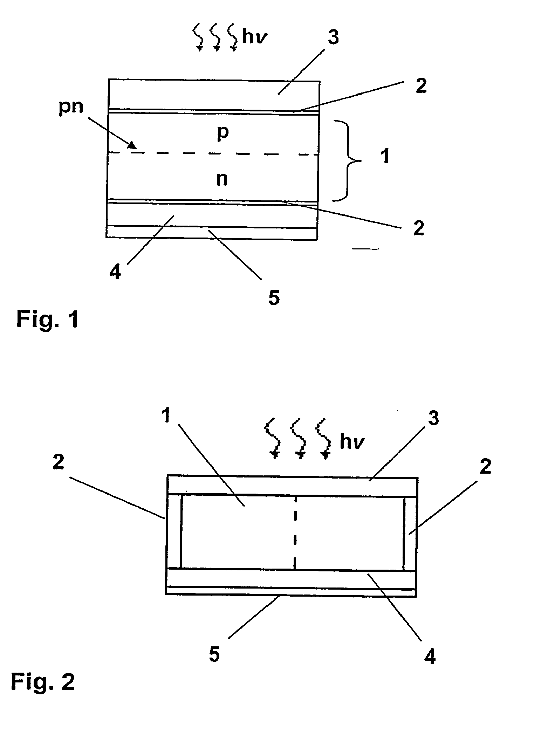

Figur 1 zeigt einen photovoltaischen Schichtbereich (1), der über zwei jeweils in den Schichten angeordneten Elektrodenanordnungen kontaktiert ist. Beispielsweise kann der photovoltaische Schichtbereich 1 durch einen je eine p-dotierte und eine n-dotierte Halbleiterschicht realisiert werden. An der Grenzfläche zwischen der p- und der n-dotierten Schicht, dem pn-Übergang, bildet sich eine Raumladungszone aus und es entsteht einer Potentialdifferenz über der Raumladungszone, die an den Elektroden in Form einer elektrischen Spannung abgreifbar ist.

Photonen hv mit einer Mindestenergie Eₘᵢₙ können in der Raumladungszone absorbiert werden, wobei ein Elektron aus dem Valenzband in das Leitungsband des Halbleiters gehoben wird. Auf diese Weise entsteht im Leitungsband ein frei bewegliches Elektron und im Valenzband ein frei bewegliches Loch. Pro absorbiertes Photon entsteht demzufolge ein Elektron-Loch-Paar. Dieses wird durch die sich am pn-Übergang ausbildende Potentialdifferenz räumlich getrennt. Das frei bewegliche Loch und das frei bewegliche Elektron wandern zu der einen bzw. zu der anderen Elektrode 2 und erzeugen einen elektrischen Stromfluss zwischen den Elektroden 2.

Die Elektrodenanordnungen 2 sollten in der in Figur 1 gezeigten Anordnung weitgehend transparent für die einfallenden Photonen hv sein. Beispielsweise können diese durch transparente ITO-Elektroden realisiert sein oder durch speziell strukturierte Elektroden, die den photovoltaischen Schichtbereich nicht ganzflächig bedecken, so dass Photonen in den photovoltaischen Schichtbereich einkoppeln können.

An die Elektroden 2 grenzen eine erste Wechselwirkungsschicht 3 sowie eine zweite Wechselwirkungsschicht 4 an. Vorzugsweise entspricht die Wechselwirkungsschicht 3 einer Down-Konversions-Schicht, in der hochenergetische Photonen derart mit der Down-Konversions-Schicht in Wechselwirkung treten, so dass ein oder mehrere Photonen niedrigerer Energie emittiert werden. Idealerweise liegt die Energie der emittierten Photonen im Absorptionsbereich des photovoltaischen Schichtbereichs 1.

Die Wechselwirkungsschicht 4 ist als Up-Konversions-Schicht ausgebildet, in der die Photonen hv, die eine zu niedrige Energie haben, um in der Wechselwirkungsschicht 3 oder im photovoltaischen Schichtbereich 1 absorbiert zu werden, im Rahmen eines Mehrphotonenprozesses zu einem zu höher energetischen Photonen umgewandelt werden. Diese Umwandlung erfolgt in mehreren Schritten. Zunächst wird ein Elektron durch Absorption eines ersten niederenergetischen Photons in ein erstes Zwischenniveau gehoben, von dem es aus direkt oder nach Relaxation in ein weiteres Zwischenniveau durch Absorption eines weiteren, zweiten niederenergetischen Photons in ein noch höher gelegenes Energieniveau angehoben wird. Von dort aus fällt das Elektron in den Grundzustand zurück und emittiert ein höher energetisches Photon, das über genügend Energie verfügt, um im photovoltaischen Schichtbereich 1 ein Elektron-Loch-Paar zu erzeugen. Da die Emission des Photons in allen Raumrichtungen erfolgt, ist es besonders günstig, wenn an der Wechselwirkungsschicht 4 eine Reflektorschicht 5 angrenzt, die die Photonen, die in einen dem photovoltaischen Schichtbereich 1 abgewandten Raumwinkelbereich emittiert wurden, reflektiert, so dass diese ebenfalls den photovoltaischen Schichtbereich 1 durchlaufen können. Vorteilhaft wirkt sich eine solche Reflektorschicht 5 auch für Photonen aus, die zwar ausreichend viel Photonenenergie besitzen, aber dennoch nicht beim einmaligen Durchtritt durch die photovoltaische Schicht absorbiert worden sind. Durch die Reflektorschicht 5 werden diese Photonen erneut in Richtung der photovoltaischen Schicht 1 reflektiert.

Die lösungsgemäße Solarzellenanordnung bewirkt eine deutliche Erhöhung der Quantenausbeute bzw. des Wirkungsgrades einer Solarzelle. Die Wechselwirkungsschicht 3 besteht aus einer erfindungsgemäßen optisch aktiven Glaskeramik, die als Deckglas, anstelle der herkömmlichen Float- oder Einscheiben-Sicherheitsgläser, auf bereits bestehende Solarzellen/Solarmodule aufgebracht wird.

Figur 2 zeigt ein weiteres Ausführungsbeispiel für eine erfindungsgemäße Solarzelle. Der photovoltaische Schichtbereich 1 weist im Gegensatz zum ersten Ausführungsbeispiel eine zur Photoneneinfallsrichtung parallele Schichtanordnung auf. Die Elektroden 2 sind gleichfalls parallel zur Photoneneinfallsrichtung ausgebildet und angeordnet. Dies hat den großen Vorteil, dass an die Elektroden 2 keine Anforderungen hinsichtlich Transparenz gestellt werden müssen. Die Kombination einer solchen Solarzelle mit den erfindungsgemäßen Wechselwirkungsschichten erfolgt analog dem Ausführungsbeispiel 1. Auf die Erläuterung der bereits eingeführten Bezugszeichen wird oben stehend verwiesen.

### Bezugszeichenliste

- 1: Photovoltaischer Schichtbereich
- 2: Elektroden
- 3, 4: Wechselwirkungsschichten
- 5: Reflektorschicht
- hv: Einfallende Photonen

## Patentansprüche

1. Solarzelle mit wenigstens einem photovoltaischen Schichtbereich (1), der in diesen einfallende Photonen (6), deren Photonenenergie über eine Mindestphotonenenergie Eₘᵢₙ liegt, zumindest teilweise absorbiert und elektrische Ladungsträger in Form von Elektron-Loch-Paaren freisetzt, die innerhalb des photovoltaischen Schichtbereiches (1) räumlich trennbar und über wenigstens zwei mit dem photovoltaischen Schichtbereich (2) elektrisch verbundene Elektroden (2) unter Ausbildung einer elektrischen Spannung abgreifbar sind, sowie mit wenigstens einer den photovoltaischen Schichtbereich (1) zumindest teilweise überdeckenden Wechselwirkungsschicht (3 und/oder 4), in der zumindest ein Teil der einfallenden Photonen (6) einer Wechselwirkung unter Emission von Photonen höherer oder niedrigerer Photonenenergie als jener der einfallenden Photonen unterliegt,
**dadurch gekennzeichnet, dass** die wenigstens eine Wechselwirkungsschicht (3
und/oder 4) in Form einer Glaskeramik augebildet ist, wobei die Glaskeramik eine Glasmatrix aufweist, in der lokal begrenzte Bereiche mit optisch aktivem Material, das die Struktur und Größe kristalliner Nanopartikel besitzt, vorgesehen sind, mit denen die einfallenden Photonen (6) in Wechselwirkung treten, und
dass das optisch aktive Material Elemente der Seltenen Erden aufweist.

2. Solarzelle nach Anspruch 1,
**dadurch gekennzeichnet, dass** das optisch aktive Material Nanophosphore enthält.

3. Solarzelle nach Anspruch 1 oder 2,
**dadurch gekennzeichnet, dass** der photovoltaische Schichtbereich (1) einen von der Photonenenergie abhängigen Absorptionsbereich aufweist, und
dass das optisch aktive Material derart gewählt ist, dass die im Rahmen der Wechselwirkung emittierten Photonen Photonenenergien aufweisen, die in den Absorptionsbereich des photovoltaischen Schichtbereiches (1) fallen.

4. Solarzelle nach einem der Ansprüche 1 bis 3,
**dadurch gekennzeichnet, dass** der photovoltaische Schichtbereich (1) zwei sich gegenüberliegende Seitenflächen vorsieht, an denen mittel- oder unmittelbar jeweils eine Wechselwirkungsschicht (3, 4) zumindest die jeweilige Seitenfläche teilweise überdeckend anschließt,
dass eine der wenigstens zwei Wechselwirkungsschichten (3) optisch aktives Material enthält, durch das im Wege der Wechselwirkung Photonen mit niedrigerer Energie emittierbar sind als jene Photonenenergie der einfallenden Photonen (6), und
dass die andere der wenigstens zwei Wechselwirkungsschichten (4) optisch aktives Material enthält, durch das im Wege der Wechselwirkung Photonen mit höherer Energie emittierbar sind als jene Photonenenergie der einfallenden Photonen (6).

5. Solarzelle nach Anspruch 4,
**dadurch gekennzeichnet, dass** die andere Wechselwirkungsschicht (4) mit einer Schicht beschichtet oder zu einer nicht galvanisch verbundenen Reflektorschicht (5) benachbart ist, die die Photonen höherer Energie und/oder die einfallenden Photonen (6) zumindest teilweise reflektiert.

6. Verfahren zur Herstellung einer Solarzelle nach einem der Ansprüche 1 bis 5, **dadurch gekennzeichnet, dass** die mindestens eine Wechselwirkungsschicht, in Form einer, eine Glasmatrix aufweisenden glaskeramischen Schicht bereitgestellt wird, in deren Glasmatrix optisch aktive, kristalline Nanopartikel enthalten sind, in die Elemente der Seltenen Erden eingebracht sind, und dass die mindestens eine Wechselwirkungsschicht (3 und/oder 4) zumindest teilweise mittelbar oder unmittelbar auf einer technischen Oberfläche des photovoltaischen Schichtbereiches (1) aufgebracht wird oder dass die mindestens eine Wechselwirkungsschicht (3 und/oder 4) als Substrat zur Aufbringung des photovoltaischen Schichtbereichs (1) dient.

7. Verfahren nach Anspruch 6,
**dadurch gekennzeichnet, dass** eine erste Wechselwirkungsschicht bereitgestellt wird,
dass die erste Wechselwirkungsschicht zumindest teilweise mittelbar oder unmittelbar auf einer ersten technischen Oberfläche des photovoltaischen Schichtbereiches aufgebracht wird oder dass die erste Wechselwirkungsschicht als Substrat zur Aufbringung des photovoltaischen Schichtbereichs (1) dient und dass eine zweite Wechselwirkungsschicht zumindest teilweise mittelbar oder unmittelbar auf einer zweiten technischen Oberfläche der photovoltaischen Schicht (1) aufgebracht wird.

8. Verfahren nach Anspruch 6 oder 7,
**dadurch gekennzeichnet, dass** die mindestens eine Wechselwirkungsschicht (3 und/oder 4) in Form einer Hoch-Temperatur-Glaskeramik bereitgestellt wird, dass die Wechselwirkungsschicht als Substratmaterial dient, auf dem Halbleiterschichten, die den photovoltaische Schichtbereich (1) bilden, unmittelbar im Rahmen eines Herstellungsprozesses des photovoltaischen Schichtbereiches (1), aufgebracht oder abgeschieden werden.

9. Verfahren nach einem der Ansprüche 6 bis 8,
**dadurch gekennzeichnet, dass** die mindestens eine Wechselwirkungsschicht (3 und/oder 4) durch Herstellen einer Glasschmelze gewonnen wird, in die das optisch aktive Material in Form kristalliner Nanopartikel beigemischt wird.

10. Verfahren nach Anspruch 9,
**dadurch gekennzeichnet, dass** als Glasschmelze eine Schmelze aus Fluorid-Glas gewählt wird, in die Barium- und Chlor-Ionen sowie Ionen aus der Gruppe der Seltenen Erden zugesetzt werden, und
dass sich durch Temperaturbehandlung in der Glasschmelze kristalline Nanopartikel ausbilden, an denen zumindest ein Teil der Ionen aus der Gruppe der Seltenen Erden anhaftet oder in denen zumindest ein Teil der Ionen aus der Gruppe der Seltenen Erden eingebaut ist.

11. Verfahren nach Anspruch 10,
**dadurch gekennzeichnet, dass** für eine Wechselwirkungsschicht, in der Photonen niedrigerer Energie in Photonen höherer Energie umgewandelt werden, Erbium-Ionen zugesetzt werden.

12. Verfahren nach Anspruch 10,
**dadurch gekennzeichnet, dass** für eine Wechselwirkungsschicht, in der Photonen höherer Energie in Photonen niedrigerer Energie im Rahmen eines Ein-Photonen-Prozesses umgewandelt werden, Europium-Ionen zugesetzt werden.

13. Verfahren nach Anspruch 10,
**dadurch gekennzeichnet, dass** für eine Wechselwirkungsschicht, in der Photonen höherer Energie in Photonen niedrigerer Energie im Rahmen eines Zwei-Photonen-Prozesses umgewandelt werden, Europium- und Gadolinium-Ionen zugesetzt werden.

## Claims

1. A solar cell with at least one photovoltaic layer region (1) which at least partially absorbs photons (6) incident in said region, the photon energy whereof lies above a minimum photon energy Eₘᵢₙ, and releases electric charge carriers in the form of electron-hole pairs, which are spatially separable inside the photovoltaic layer region (1) and can be tapped by means of at least two electrodes (2) electrically connected to the photovoltaic layer region (2) thereby forming an electric voltage, and with at least one interaction layer (3 and/or 4) which at least partially overlaps the photovoltaic layer region (1) and in which at least some of the incident photons (6) are subjected to an interaction causing the emission of photons of higher or lower photon energy than that of the incident photons, **characterised in that** the at least one interaction layer (3 and/or 4)is constituted in the form of a glass ceramic, wherein the glass ceramic comprises a glass matrix, in which locally delimited regions are provided with optically active material which has the structure and size of crystalline nanoparticles, with which the incident photons (6) enter into an interaction, and that the optically active material comprises elements of rare earths.

2. A solar cell according to claim 1,
**characterised in that** the optically active material contains nanophosphors.

3. The solar cell according to claim 1 or 2, **characterised in that** the photovoltaic layer region (1) comprises an absorption region dependent on the photon energy, and that the optically active material is selected such that the photons emitted in the course of the interaction have photon energies which fall within the absorption range of the photovoltaic layer region (1).

4. The solar cell according to any one of claims 1 to 3, **characterised in that** the photovoltaic layer region (1) provides two opposite lateral faces, which are each adjoined indirectly or directly by an interaction layer (3, 4) partially overlapping at least the respective lateral face,
that one of the at least two interaction layers (3) contains optically active material, by means of which photons with a lower energy than the photon energy of the incident photons (6) can be emitted by way of interaction,
and
that the other of the at least two interaction layers (4) contains optically active material, by means of which photons with higher energy than the photon energy of the incident photons (6) can be emitted by way of interaction.

5. The solar cell according to claim 4, **characterised in that** the other interaction layer (4) is coated with a layer or is adjacent to a non-galvanically connected reflection layer (5), which at least partially reflects the photons of higher energy and/or the incident photons (6).

6. A method for the production of a solar cell according to any one of claims 1 to 5, **characterised in that** the at least one interaction layer is provided in the form of a glass-ceramic layer comprising a glass matrix, in the glass matrix whereof optically active, crystalline nanoparticles are contained, into which elements of the rare earths are introduced, and that the at least one interaction layer (3 and/or 4) is deposited at least partially indirectly or directly on a technical surface of the photovoltaic layer region (1) or that the at least one interaction layer (3 and/or 4) serves as a substrate for the deposition of the photovoltaic layer region (1).

7. The method according to claim 6, **characterised in that** a first interaction layer is provided,
that the first interaction layer is deposited at least partially indirectly or directly on a first technical surface of the photovoltaic layer region or that the first interaction layer serves as a substrate for the deposition of the photovoltaic layer region (1) and that a second interaction layer is deposited at least partially indirectly or directly on a second technical surface of the photovoltaic layer (1).

8. The method according to claim 6 or 7, **characterised in that** the at least one interaction layer (3 and/or 4) is provided in the form of a high-temperature glass ceramic, that the interaction layer serves as a substrate material, on which semiconductor layers forming the photovoltaic layer region (1) are applied or deposited directly in the course of the production process of the photovoltaic layer region (1).

9. The method according to any one of claims 6 to 8, **characterised in that** the at least one interaction layer (3 and/or 4) is obtained by producing a glass melt, into which the optically active material in the form of crystalline nanoparticles is mixed.

10. The method according to claim 9, **characterised in that**, as a glass melt, a melt of fluoride glass is selected, to which barium and chlorine ions as well as ions from the group of rare earths are added, and that, as a result of heat treatment, there are formed in the glass melt crystalline nanoparticles to which at least some of the ions from the group of rare earths adhere or in which at least some of the ions from the group of rare earths are embedded.

11. The method according to claim 10, **characterised in that** erbium ions are added for an interaction layer in which photons of lower energy are converted into photons of higher energy.

12. The method according to claim 10, **characterised in that** europium ions are added for an interaction layer in which photons of higher energy are converted into photons of lower energy in the course of a one-photon process.

13. The method according to claim 10, **characterised in that** europium and gadolinium ions are added for an interaction layer in which photons of higher energy are converted into photons of lower energy in the course of a two-photon process.

## Revendications

1. Cellule solaire comprenant au moins une zone de couche (1) photovoltaïque, qui est absorbée au moins partiellement dans des photons (6) entrant dans cette zone, photons dont l'énergie se situe au-dessus d'une énergie de photons minimale Eₘᵢₙ, et libère des porteurs de charge sous forme de paires électron-trou, qui peuvent être séparés dans l'espace à l'intérieur de la zone de couche (1) photovoltaïque et peuvent être prélevés par au moins deux électrodes (2) reliées électriquement à la zone de couche (2) photovoltaïque en formant une tension électrique, et comprenant au moins une couche d'interaction (3 et/ou 4) recouvrant au moins partiellement la zone de couche (1) photovoltaïque, couche d'interaction dans laquelle au moins une partie des photons (6) entrant est soumise à une interaction en émettant des photons d'énergie plus élevée ou plus faible que celle des photons entrant, **caractérisée en ce que** la au moins une couche d'interaction (3 et/ou 4) est conçue sous la forme d'une vitrocéramique, la vitrocéramique présentant une matrice de verre dans laquelle sont prévues des zones limitées localement avec un matériau optiquement actif, qui présente la structure et la grandeur de nanoparticules cristallines, particules avec lesquelles les photons (6) entrant entrent en interaction, et **en ce que** le matériau optiquement actif présente des éléments des terres rares.

2. Cellule solaire selon la revendication 1, **caractérisée en ce que** le matériau optiquement actif contient des nano-phosphores.

3. Cellule solaire selon la revendication 1 ou 2, **caractérisée en ce que** la zone de couche (1) photovoltaïque présente une zone d'absorption dépendante de l'énergie des photons, et **en ce que** le matériau optiquement actif est choisi de telle sorte que les photons émis dans le cadre de l'interaction présentent des énergies de photons qui rentrent dans la zone d'absorption de la zone de couche (1) photovoltaïque.

4. Cellule solaire selon l'une des revendications 1 à 3, **caractérisée en ce que** la zone de couche (1) photovoltaïque présente deux faces latérales se faisant face, faces auxquelles se raccorde indirectement ou directement à chaque fois une couche d'interaction (3, 4) en recouvrant partiellement au moins la face latérale respective,
**en ce que** l'une des au moins deux couches d'interaction (3) contient du matériau optiquement actif, par lequel, par le biais de l'interaction, on peut émettre des photons présentant une énergie plus faible que l'énergie des photons entrant (6), et
**en ce que** l'autre des au moins deux couches d'interaction (4) contient du matériau optiquement actif, par lequel, par le biais de l'interaction, on peut émettre des photons présentant une énergie plus élevée que l'énergie des photons (6) entrant.

5. Cellule solaire selon la revendication 4, **caractérisée en ce que** l'autre couche d'interaction (4) est recouverte d'une couche ou est située à proximité d'une couche de réflexion (5) non reliée galvaniquement, qui réfléchit au moins partiellement les photons d'énergie supérieure et/ou les photons (6) entrant.

6. Procédé pour fabriquer une cellule solaire selon l'une des revendications 1 à 5,
**caractérisée en ce que** la au moins une couche d'interaction, est mise à disposition sous la forme d'une couche de vitrocéramique, présentant une matrice en verre, couche dans la matrice en verre de laquelle sont incluses des nanoparticules optiquement actives et cristallines, dans lesquelles sont introduits des éléments des terres rares, et **en ce que** la au moins une couche d'interaction (3 et/ou 4) est appliquée au moins partiellement indirectement ou directement sur une surface technique de la zone de couche (1) photovoltaïque ou **en ce que** la au moins une couche d'interaction (3 et/ou 4) sert de substrat pour l'application de la zone de couche (1) photovoltaïque.

7. Procédé selon la revendication 6,
**caractérisé en ce qu'**une première couche d'interaction est mise à disposition,
**en ce que** la première couche d'interaction est appliquée au moins partiellement indirectement ou directement sur une première surface technique de la zone de couche photovoltaïque ou **en ce que** la première couche d'interaction sert de substrat pour l'application de la zone de couche (1) photovoltaïque et **en ce qu'**une seconde couche d'interaction est appliquée au moins partiellement indirectement ou directement sur une seconde surface technique de la couche photovoltaïque (1).

8. Procédé selon la revendication 6 ou 7, **caractérisé en ce que** la au moins une couche d'interaction (3 et/ou 4) est mise à disposition sous la forme d'une vitrocéramique à température élevée, **en ce que** la couche d'interaction sert de matériau de substrat, sur lequel des couches à semi-conducteurs, qui forment la zone de couche photovoltaïque (1), sont appliquées ou déposées directement dans le cadre d'un processus de fabrication de la zone de couche photovoltaïque (1).

9. Procédé selon l'une des revendications 6 à 8, **caractérisé en ce que** la au moins une couche d'interaction (3 et/ou 4) est obtenue par fabrication d'une masse fondue de verre, dans laquelle le matériau visuellement actif est mélangé sous forme de nanoparticules cristallines.

10. Procédé selon la revendication 9,
**caractérisé en ce qu'**une masse fondue à base de fluorure et de verre est choisie comme masse fondue de verre, masse dans laquelle des ions de baryum et de chlore ainsi que des ions provenant du groupe des terres rares sont ajoutés,
et **en ce que** des nanoparticules cristallines se forment par traitement de la température dans la masse fondue de verre, particules sur lesquelles s'accroche au moins une partie des ions provenant du groupe des terres rares ou dans lesquelles au moins une partie des ions provenant du groupe des terres rares est intégrée.

11. Procédé selon la revendication 10,
**caractérisé en ce que** des ions d'erbium sont ajoutés pour une couche d'interaction, dans laquelle des photons d'énergie plus faible sont transformés en photons d'énergie plus élevée.

12. Procédé selon la revendication 10,
**caractérisé en ce que** des ions d'europium sont ajoutés pour une couche d'interaction, dans laquelle des photons d'énergie plus élevée sont transformés en photons d'énergie plus faible dans le cadre d'un processus à un photon.

13. Procédé selon la revendication 10,
**caractérisé en ce que** des ions d'europium et de gadolinium sont ajoutés pour une couche d'interaction, dans laquelle des photons d'énergie plus élevée sont transformés en photons d'énergie plus faible dans le cadre d'un processus à deux photons.
